# EUROPEAN PATENT APPLICATION

(11) **EP 2 339 622 A1**
(43) Date of publication of application: **29.06.2011**
(21) Application number: 09180586.1
(22) Date of filing: 23.12.2009
(51) Int. Cl.: H01L 23/485, H01L 21/60, H01L 29/06

(54) **Wirebonding Process**

(71) Applicant: NXP B.V., 5656 AG Eindhoven (NL)
(72) Inventor: Hochstenback, Hendrik Pieter, Redhill, Surrey RH1 1DL (GB); Van Driel, Willem, Redhill, Surrey RH1 1DL (GB); Ooms, Eric, Redhill, Surrey RH1 1DL (GB)
(74) Representative: Burton, Nick

(57) **Abstract**

A wirebonding process comprises forming a bond pad (30) with a roughened upper surface (32), lowering a copper wirebond ball (14) onto the roughened bond bad, and applying a force to the wirebond ball against the roughened surface, A heat treatment is applied to form the bond between the wirebond ball and the roughened surface, wherein the bond is formed without use of ultrasonic energy.
This process avoids the use of ultrasonic welding and thereby reduces the occurrence of microcracks and resulting Chip Out of the Bond (COUB) and Metal Peel Off (MPO) failures. The roughened surface of the bond pad improves the reliability of the connection.

## Description

This invention relates to wirebonding processes, for example for use in the manufacture of an interconnection within a semiconductor device, comprising of a bondpad and a wire.

Wirebonding is still the dominant form of first level interconnection in the world today. Approximately 95% of manufactured packages (in volume) are wirebonded.

The bond wires are usually gold, aluminum or copper. The wire diameters start at 15 micrometers and can be up to several hundred micrometres for high-powered applications.

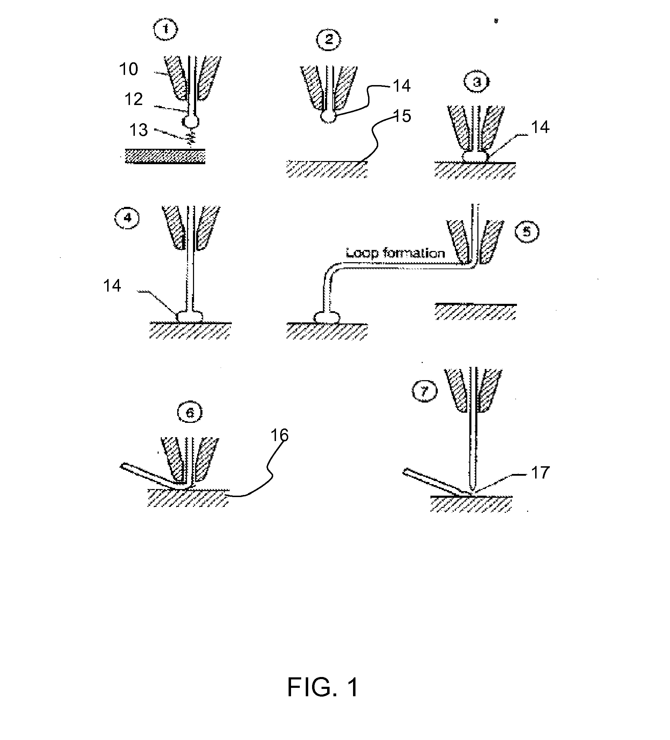

Figure 1 shows an example of known ball/wedge wirebonding process.

A capillary tool holds the wire 12. In order to create the ball end 14 of the wire, an arc 13 is struck as shown in step 1 of Figure 1. The ball is lowered onto the chip bond pad (step 2) and ultrasonic energy, pressure and heat are applied to form the ball bond 14 (step 3). This combination of heat, pressure, and ultrasonic energy forms a weld. Loop formation is carried out (steps 4 and 5) and then a tail (i.e. the wedge) is formed on the package bond pad 16, again using ultrasonic energy, pressure and heat (step 6). The resulting bond is a stitch bond 17 (step 7).

As silicon technology progresses towards higher integration, increasing demands are being placed on the bond pad pitch. The smaller the pad pitch, the less die surface is taken by the bond pad. This results in a larger number of dice and higher revenue per wafer. Shrinking the bond pad on the die has a domino effect on the entire technology of wirebonding. From designing the bond pad on the die to materials selection, process optimisation and reliability issues, there are many factors to consider in order to make zero-defect wirebonding a viable manufacturing technology. In particular, the process optimisation demands proper capillary design and selection, appropriate parameter settings of the bonder and optimal process control.

As outlined above, ultrasonic technologies are used to create contact between the ball and the bond pad and between the stitch and the lead.

During wirebonding, the construction under the bond pad can be damaged due to the power and/or energy applied on the bond pad during the wirebonding process. The wirebond process applies power and forces on the bond-pad surface, and the bond-pad must withstand the power and forces. When the wirebond forces and power exceed the absorbing capabilities of the bond-pad system or construction, damages under the pad can occur. These damages can be micro-cracks in a passivation layer under the pad or complete chip out. Examples of such damage are so-called Chip Out of the Bond (COUB) and/or Metal Peel Off (MPO).

There are two ways to overcome these problems:
1. Optimise the wirebond parameters; typically reduce the down force and/or the ultrasonic movement;
2. Improve the bondpad construction by making it more robust; typically increase the top metal thickness.

This invention is directed specifically to the wirebonding process. During the wire-bonding process, the ball is pushed with an applied force on the pad, followed by the ultrasonic energy step. It is known that the ultrasonic step can be the cause of the COUB and/or MPO failures. However, the ultrasonic step is needed in order to make the physical connection between the wire and the bondpad. During this step the intermetallics are formed, which connect the wire mechanically and electrically to the chip.

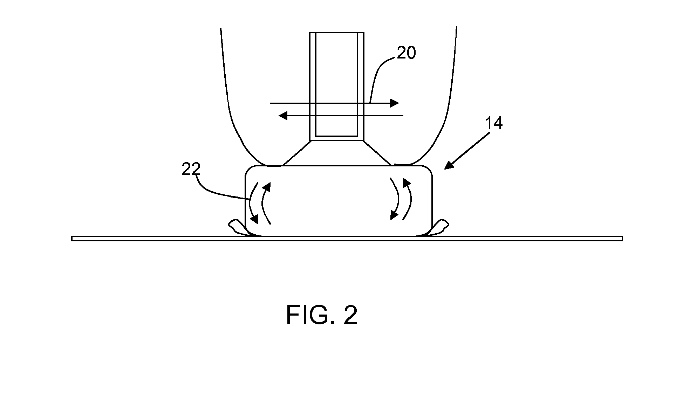

Figure 2 is used to explain how the intermetallics are formed. Arrows 20 represent the ultrasonic movement. This causes rolling of the ball (arrows 22), deforming the underlying (aluminium) bond bad surface. However, tensile stresses in the silicon can also result so that small cracks can occur. Silicon has a much higher compressive strength than tensile strength so tensile stresses should be avoided.

The invention is particularly directed to the use of copper wires instead of gold. Copper wire has become one of the preferred materials for wirebonding interconnects in many semiconductor and microelectronic applications. Copper is used for fine wire ball bonding typically in sizes up to 75 microns. Copper wire has the ability of being used at smaller diameters providing the same performance as gold without the high material cost. However, there are particular quality and reliability problems which are encountered.

There is therefore a need for an improved wirebonding process for copper wire which can reduce the problems associated with ultrasonic welding and maintain a fault free wirebonding process.

According to the invention, there is provided a wirebonding process comprising:
forming a bond pad with a roughened upper surface;
lowering a copper wirebond ball onto the roughened bond bad;
applying a force to the wirebond ball against the roughened surface;
applying heat treatment to form the bond between the wirebond ball and the roughened surface, wherein the bond is formed without use of ultrasonic energy.

This process avoids the use of ultrasonic welding and thereby reduces the occurrence of microcracks and resulting Chip Out of the Bond (COUB) and Metal Peel Off (MPO) failures. The roughened surface of the bond pad improves the reliability of the connection.

The roughened upper surface can comprise an array of projections on the surface of the bond pad.

Alternatively, the roughened upper surface can comprise a well in the surface of the bond pad.

The bond pad upper surface can comprise aluminium.

Forming the roughened upper surface can comprise patterning a silicon surface beneath the upper surface before depositing the material of the upper surface.

Examples of the invention will now be described in detail with reference to the accompanying drawings, in which:
Figure 1 shows a known ball/wedge wirebonding process;
Figure 2 shows how the ultrasonic energy used influences the bonding process;
Figure 3 shows a first example of wirebonding process of the invention;
Figure 4 shows a second example of wirebonding process of the invention; and
Figure 5 shows an example of how to form a roughened surface.

The invention relates to a wirebonding process which avoids the need for ultrasonic welding, but improves the mechanical coupling between a bond wire and bond pad, in particular by providing a roughened bond pad surface.

The quality and reliability of the interconnection between the bondpad and the wire (the so-called wirebond) can then be achieved. This provides a solution to the current quality and reliability problems that are encountered with wirebonding, particularly when using copper instead of gold.

The invention is based on the recognition that the ultrasonic step can be removed if certain countermeasures are taken within the bondpad construction.

In particular, without the ultrasonic welding step, and with thermal annealing only, it is necessary to prevent the wire ball falling off the pad after placement. For this purpose, the surface of the bondpad is roughened.

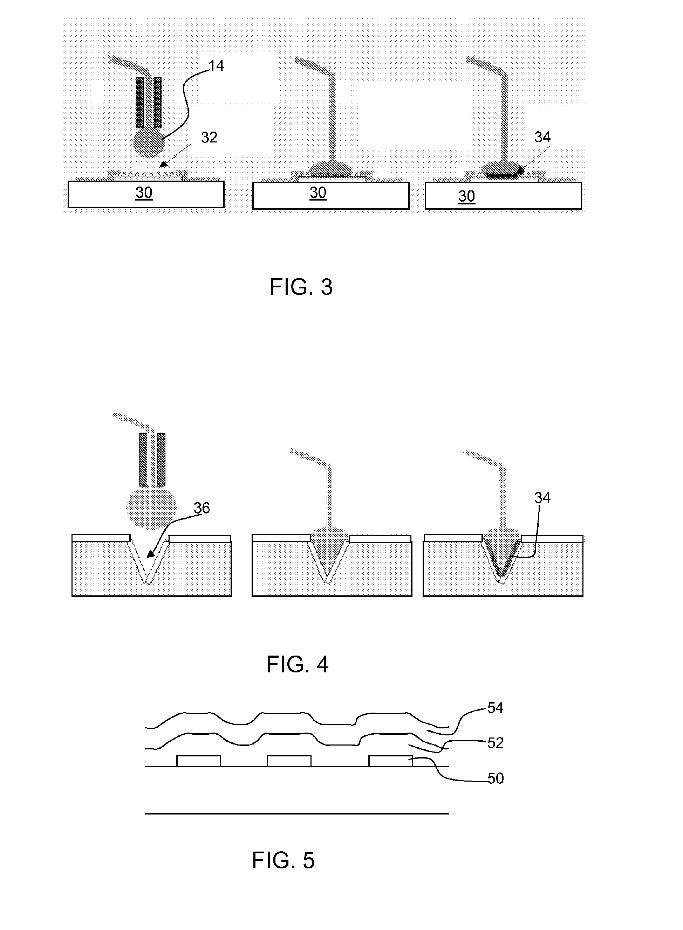

Figure 3 shows a first example of process resulting in the arrangement as shown in the first step of Figure 3.

The wire ball 14 at the end of the wire is formed in conventional manner.

The surface of the bond pad 30 is provided with an array of projections 32 as shown.

In the second step, the ball is pressed against the surface with a desired force, but no ultrasonic power. In the third step, the intermetallics 34 are formed by heat treatment.

The ball on the wire is pinned into the structure of the roughened surface, and this improves the retention of the ball against the bond pad.

In one example, the roughness is created by using metal structures in a lower metal layer, which are then transported by non-planarised layers to the top surface.

This is shown in Figure 5. The metal pattern in a lower metal layer is shown as 50. A non-planarized layer (e.g. dielectric layer) is shown as 52 and the top metal layer is shown as 54. The pattern of pads 50 in the lower layer translates to a roughened upper surface.

The pattern in the lower metal layer can comprise metal pads for example of dimension 1µm by 1 µm with a spacing of 1µm (i.e. a regular array of pads). More generally, an arrangement of pads of area less than 100 (µm)² can be used and more preferably less than 10 (µm)² so that a micro-roughened surface results. The pads cover an area of at least 10% of the total area, so that they are arranged in a dense configuration.

In another example, the array of projections can be made by micro-machining the silicon surface prior to the metal (Aluminium) deposition and/or by etching tiling structures within the aluminium top layer of the bondpad.

Variations to the array of projections are possible. For example, Figure 4 shows an example in which the roughened surface comprises a channel 36. Other variations are possible, such as multiple grooves, flakes, tilings and/or metal plates in the bondpad all with the purpose to increase the surface roughness.

The heat treatment step provides the desired intermetallics. This provides a thermal annealing between the wirebond ball and bond pad material. The thermal anneal step can carried out in a batch oven, preferably under a nitrogen environment to prevent the construction from oxidation. Another way of annealing can be done with RTA (Rapid Thermal Anneal), which is well known in the semiconductor industry to anneal implants in silicon to obtain steep diffusion profiles. Also laser annealing can be used to anneal the connection between the wire ball and pad after the ball is deformed on the pad.

The invention is of particular interest for bonding a copper wire to an aluminium bond pad surface, but other bond pad surfaces such as aluminium or gold are possible.

Various modifications will be apparent to those skilled in the art.

## Claims

1. A wirebonding process comprising:
forming a bond pad with a roughened upper surface (32);
lowering a copper wirebond ball (14) onto the roughened bond bad;
applying a force to the wirebond ball against the roughened surface;
applying heat treatment to form the bond (34) between the wirebond ball and the roughened surface, wherein the bond is formed without use of ultrasonic energy.

2. A process as claimed in claim 1, wherein the roughened upper surface (32) comprises an array of projections on the surface of the bond pad.

3. A process as claimed in claim 1, wherein the roughened upper surface comprises a well (36) in the surface of the bond pad.

4. A process as claimed in any preceding claim, wherein the bond pad upper surface comprises aluminium.

5. A process as claimed in any preceding claim, wherein forming the roughened upper surface comprises patterning a silicon surface beneath the upper surface before depositing the material of the upper surface.

6. A process as claimed in any one of claims 1 to 4, wherein forming the roughened upper surface comprises forming a metal pattern (50) in a lower metal layer, and forming an upper metal layer (54) over the top.

7. A process as claimed in claim 6, further comprising forming a non-planarized spacer layer (52) between the lower and upper metal layers.

8. A process as claimed in claim 6 or 7, wherein the metal pattern (50) comprises an array of pads, each having an area less than 100µm² and covering an area of at least 10% of the total area.

9. A process as claimed in claim 8, wherein the pads each have an area less than 10µm².
